# EUROPEAN PATENT APPLICATION

(11) **EP 2 192 609 A1**
(43) Date of publication of application: **02.06.2010**
(21) Application number: 09177236.8
(22) Date of filing: 26.11.2009
(51) Int. Cl.: H01L 21/02

(54) **Method of producing wafer for active layer**

(30) Priority: 28.11.2008 JP 2008303826
(71) Applicant: SUMCO Corporation, Tokyo 105-8634 (JP)
(72) Inventor: Nishihata, Hideki, Tokyo 105-8634 (JP); Endo, Akihiko, Tokyo 105-8634 (JP); Morita, Etsurou, Tokyo 105-8634 (JP)
(74) Representative: Cabinet Plasseraud

(57) **Abstract**

A wafer for active layer is produced by a method comprising a slicing step for cutting out a disc-shaped wafer from a single crystal silicon ingot, a beveling step for beveling an edge portion of the sliced wafer, a grinding step for grinding each surface of the beveled wafer, an etching step for etching the surface of the ground wafer and a single-sided mirror-polishing step for mirror-polishing only one surface of the etched wafer.

## Description

### BACKGROUND OF THE INVENTION

### 1. Field of the Invention

This invention relates to a method of producing a wafer for active layer to be used in a bonded wafer and, more particularly to a method of producing a wafer for active layer which is excellent in terms of cost as compared with the conventional method of producing a silicon wafer.

### 2. Description of the Related Art

The conventional method of producing a wafer for active layer comprises a slicing step for slicing a single crystal silicon ingot pulled with a single crystal pulling apparatus to obtain a disc-shaped wafer, a beveling step for beveling an outer peripheral edge portion of the wafer to prevent the occurrence of cracks or breaks in the sliced wafer, a lapping step for planarizing a surface of the beveled wafer, an etching step for removing an affected layer produced by the beveling and lapping, a double-sided mirror-polishing step for mirror-polishing the surface of the etched wafer, and so on. For example, non-patent document (UCS semiconductor substrate technology society: "Science of Silicon" REALIZE INC., June 28, 1996, pp244-315) discloses the technique of conducting a slicing step, a lapping step, a beveling step, an etching step and a polishing step in series.

As the planarizing step, it is common to adopt a technique that a high-accuracy planarization of a wafer is conducted through a grinding step using a surface grinding machine or a double-sided simultaneous grinding machine instead of the lapping step to reduce a variation or undulation in the thickness of the wafer. As the surface grinding machine is generally known an infeed type surface grinding machine wherein a wafer is placed on a chuck table rotating at a high speed and a cup-type grinding stone is continuously cut into the wafer for grinding. As the double-sided simultaneous grinding machine are known a single wafer type double-sided grinding machine wherein a plurality of as-cut wafers are sequentially fed between an upper grinding stone and a lower grinding stone driving at a high speed while placing these wafers on a carrier driving at a low speed in a direction opposite to the driving direction of the grinding stones, a batch type double-sided grinding machine wherein upper and lower grinding stones are attached to the respective upper and lower platens and plural wafers placed in receiving holes of a carrier are interposed between the upper and lower grinding stones and then both surfaces of the plural wafers are simultaneously ground by the rotation of the lower platen and the pressurization through the upper platen, and so on.

As such a method of producing a silicon wafer, Japanese Patent No. 328,193 discloses a method of producing a semiconductor wafer, which comprises a slicing step for slicing a single crystal ingot to obtain a disc-shaped wafer, a surface grinding step for planarizing a surface of the wafer, a beveling step for beveling an outer peripheral edge portion of the wafer and a polishing step for mirror-polishing the surface of the wafer, wherein a double-sided simultaneous primary grinding step for simultaneously grinding the both surfaces of the wafer with a double-sided grinding machine is conducted before the beveling step, and a secondary grinding step after the beveling step is conducted by an infeed type one-sided grinding with cup-type grinding stones through one-sided adsorption.

In the production methods of the above non-patent document and patent document, the resulting wafer has a desired flatness, but there are problems that the production cost is elevated and the production steps become complicated. Since such problems remarkably appear in a large-size silicon wafer particularly having a diameter of not less than 300 mm, future remediation is required.

### SUMMARY OF THE INVENTION

With the foregoing in mind, it is an object of the invention to provide a method of producing a wafer for active layer in which an active layer having a good flatness can be produced easily with a low cost with respect to a large-size wafer particularly having a diameter of not less than 300 mm.

The inventors have made various studies on the production method of wafers for active layer for solving the above problems. As a result, it is focused that since a greater part of the wafer for active layer constituting a bonded wafer is removed by grinding or the like different from a wafer for support substrate, only a bonding surface is required to have a high flatness.

As a result of further studies, it has been found that when the method of producing a wafer for active layer comprises a slicing step for cutting out a disc-shaped wafer from a single crystal ingot, a beveling step for beveling an edge portion of the sliced wafer, a grinding step for grinding each surface of the beveled wafer, an etching step for etching the surface of the ground wafer and a single-sided mirror-polishing step for mirror-polishing only one surface of the etched wafer, an active layer having a good flatness can be produced but also the wafer can be produced more easily with a lower cost because there is no need to conduct the conventional complicated steps such as double-sided grinding step, edge polishing step, double-sided polishing step and the like.

The invention is based on the above knowledge and the summary and construction thereof are as follows:
(1) A method of producing a wafer for active layer, which comprises a slicing step for cutting out a disc-shaped wafer from a single crystal silicon ingot, a beveling step for beveling an edge portion of the sliced wafer, a grinding step for grinding each surface of the beveled wafer, an etching step for etching the surface of the ground wafer and a single-sided mirror-polishing step for mirror-polishing only one surface of the etched wafer surfaces.

(2) A method of producing a wafer for active layer according to the item (1), wherein the single-sided mirror-polishing step comprises a polishing for reducing nanotopography on one surface of the wafer and a finish polishing for reducing surface roughness of one surface of the wafer.

(3) A method of producing a wafer for active layer according to the item (1) or (2), wherein the single-sided mirror-polishing step is conducted by applying a given polishing solution substantially containing no abrasive grain onto a surface of a polishing pad having fixed abrasive grains, and moving the polishing pad relative to a fixed silicon wafer to polish one surface of the wafer.

(4) A method of producing a wafer for active layer according to the item (2) or (3), wherein the polishing in the single-sided mirror-polishing step is conducted until the nanotopography measured in an area of 10 mm × 10 mm is reduced to not more than 10 nm.

(5) A method of producing a wafer for active layer according to any one of the items (2) to (4), wherein the finish polishing in the single-sided mirror-polishing step is conducted until the surface roughness (RMS value) measured in an area of 30 µm × 30 µm is reduced to not more than 1 nm.

(6) A method of producing a wafer for active layer according to any one of the items (1) to (5), wherein the wafer cut out from the ingot in the slicing step has a thickness of 300 to 700 µm.

(7) A method of producing a wafer for active layer according to any one of the items (1) to (6), wherein a diameter of the wafer for active layer is not less than 300 mm.

According to the invention, it is made possible to provide a method of producing a wafer for active layer wherein an active layer having a good flatness can be produced easily with a low cost with respect to a large size wafer particularly having a diameter of not less than 300 mm.

### BRIEF DESCRIPTION OF THE DRAWINGS

FIG. 1 is a flow chart illustrating steps in a method of producing a wafer for active layer according to the invention;
FIG. 2 is a flow chart illustrating steps in the conventional method of producing a silicon wafer; and
FIG. 3 is photographs illustrating presence or absence of undulations on a surface of a wafer for active layer produced according to the flow chart of FIG. 1, wherein (a) shows a state of leaving undulations on a back surface of the wafer after back surface grinding, (b) shows a state of leaving undulations on a front surface of the wafer after front surface grinding and (c) shows a state of leaving no undulation on the front surface of the wafer after front surface (one-sided surface) polishing.

### DESCRIPTION OF THE PREFERRED EMBODIMENTS

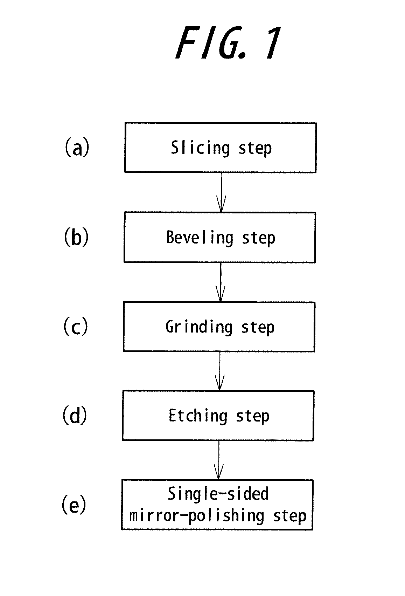

The method of producing a wafer for active layer according to the invention will be described in detail with reference to the drawings. FIG. 1 is a flow chart illustrating the method of producing a wafer for active layer according to the invention, wherein FIGS. 1(a) to 1(e) illustrate each step, respectively.

The method of producing a wafer for active layer according to the invention comprises a slicing step for cutting out a disc-shaped wafer from a single crystal silicon ingot (FIG. 1(a)), a beveling step for beveling an edge portion of the sliced wafer (FIG. 1(b)), a grinding step for grinding each surface of the beveled wafer (FIG. 1(c)), an etching step for etching the surface of the ground wafer (FIG. 1(d)) and a single-sided mirror-polishing step for mirror-polishing only one surface of the etched wafer surfaces (FIG. 1(e)).

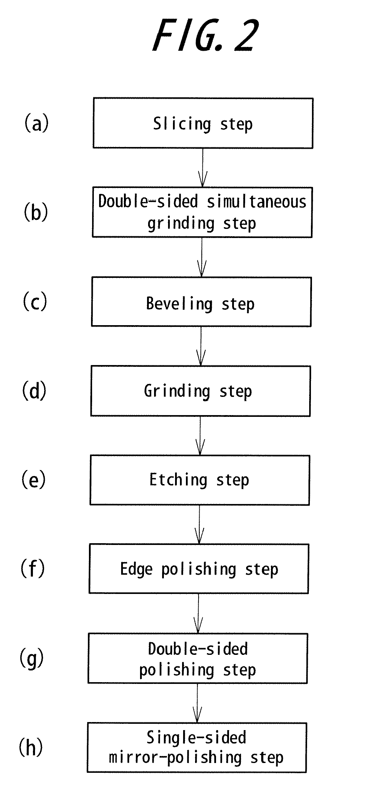

On the other hand, FIG. 2 is a flow chart illustrating the conventional steps for producing a silicon wafer, wherein FIGS. 2(a) to 2(h) illustrate each step, respectively. In the conventional method of producing a silicon wafer, a double-sided simultaneous grinding step (FIG. 2(b)), an edge polishing step (FIG. 2(f)) and a double-sided polishing step (FIG. 2(g)) are conducted extra as compared with the steps in the method of producing a wafer for active layer according to the invention (FIGS. 1(a) to 1(e)), so that efforts, time and cost required for the production are increased as compared with the production method of the invention.

Next, each step in the method of producing a wafer for active layer according to the invention will be explained.

### Slicing step

The slicing step of the invention (FIG. 1(a)) is a step that a disc-shaped silicon wafer is obtained from a single crystal ingot by bringing a wire saw into contact with the single crystal ingot while feeding a grinding solution or by cutting the single crystal ingot with a circular inner peripheral blade. Moreover, the wafer for active layer after the slicing step is preferable to have the highest flatness possible and the smallest surface roughness possible in order to reduce processing load in the subsequent grinding step (FIG. 1(c)).

In the slicing step (FIG. 1(a)), the thickness of the wafer cut out from the ingot is preferable to be in a range of 300 to 700 µm. When the thickness is not more than 700 µm, the cost reduction effect of the invention is further improved, while when it is less than 300 µm, the wafer is too thin and there is a possibility that the wafer is damaged in the cutting.

### Beveling step

The beveling step (FIG. 1(b)) of the invention is a step that an edge portion of the wafer cut out from the single crystal ingot at the slicing step (FIG. 1(a)) is beveled by grinding and polishing.

Since the beveling method is not particularly limited, the beveling may be concretely conducted by a common beveling method on a silicon wafer. For example, the beveling can be attained by grinding the edge portion of the wafer with a grinding stone made of diamond having a roughness of about #800 to 2000.

If necessary, the beveled portion after the above beveling may be subjected to polishing for further reducing the variation in beveled width. For example, the beveled portion is polished with a polishing cloth made from urethane or the like while feeding a polishing slurry. The kind of polishing slurry is not particularly limited, and it is possible to use a slurry containing colloidal silica with a grain size of about 0.5 µm or the like.

### Grinding step

The grinding step (FIG. 1(c)) of the invention is a step that each surface of the wafer after the beveling step (FIG. 1(b)) is subj ected to a given grinding so as to set the concave-convex surface shape and thickness of the wafer. The grinding conditions are not particularly limited, and the same conditions as used at the usual grinding step may be used. For example, lapping may be performed by applying a given grinding solution onto a grinding pad made from a thermosetting resin, and moving the grinding pad relative to the wafer. Moreover, abrasive grains may be included in a grinding solution, or they may be provided on a polishing pad as fixed abrasive grains. Also, the kind thereof is not particularly limited, and may include, for example, diamond, SiC and the like.

Furthermore, it is required to perform the grinding on both surfaces of the wafer every one-side surface. The grinding of every one-side surface can reduce damages due to grinding as compared with the case of double-sided simultaneous grinding, and the grinding margin can be also reduced. This can remove undulations at both of the front and back surfaces of the wafer.

### Etching step

The etching step of the invention (FIG. 1(d)) is a step that the surface of the wafer is treated by a chemical corrosion method for the main purpose of removing an affected layer produced on the surface of the wafer at the grinding step (FIG. 1(c)). For this end, an alkali etching with NaOH or the like is conducted.

### Single-sided mirror-polishing step

In the single-sided mirror-polishing step (FIG. 1(e)) of the invention, unlike the conventional method of producing a silicon wafer, the polishing is conducted for only a surface of the wafer for active layer to be bonded, so that there is an effect in the shortening of the production time and the reduction of production cost as compared with the conventional production method. The polishing method is not particularly limited, and may be the same as used in the usual polishing step. For example, it is possible to adopt a polishing method by applying a given polishing slurry onto an abrasive cloth made from urethane or the like or a polishing method by applying a given polishing solution substantially containing no abrasive grain onto a surface of a polishing pad having fixed abrasive grains.

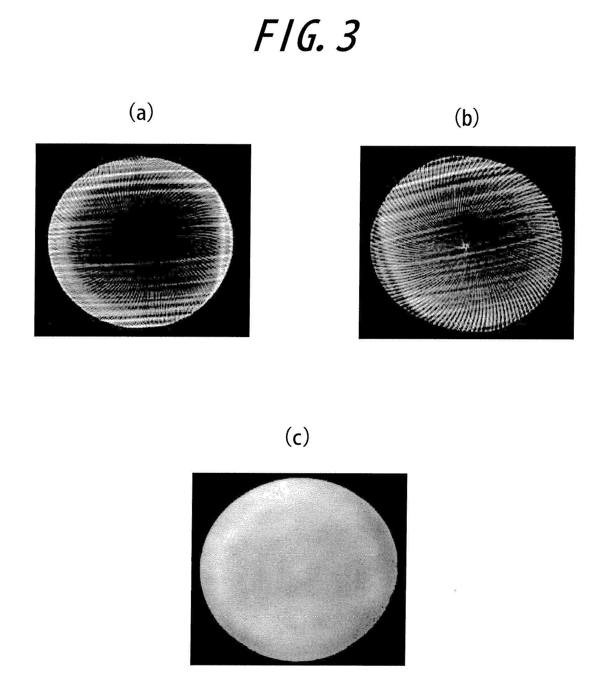

Here, FIG. 3 illustrates a state of a back surface of the wafer after back surface grinding (FIG. 3(a)), a state of a front surface of the wafer after front surface grinding (FIG. 3(b)) and a state of the front surface of the wafer after single-sided mirror-polishing step (FIG. 3(c)) in the production method of the invention. As seen from FIGS. 3(b) and 3(c), undulations on the front surface of the wafer have been completely removed in single-sided mirror-polishing step (FIG. 1(e)) by the method of the invention.

Moreover, the invention does not include a double-sided simultaneous grinding step (FIG. 2(b)) as in the conventional method of producing a silicon wafer. Therefore, from a viewpoint of surely removing undulations generated on the surface of the wafer, it is preferable to apply a method that the surface of the wafer is polished by applying a given polishing solution substantially containing no abrasive grain onto a surface of a polishing pad having fixed abrasive grains and moving the polishing pad relative to the fixed silicon wafer. If the polishing is conducted by applying a polishing solution containing abrasive grains onto a polishing pad having no abrasive grain, there is a possibility that the undulations on the wafer surface can not be removed sufficiently.

Furthermore, it is preferable that the single-sided mirror-polishing step comprises a polishing for reducing nanotopography on one surface of the wafer and a finish polishing for reducing surface roughness of one surface of the wafer. Thus, it is possible to effectively suppress the occurrence of voids on the bonded interface when a bonding surface of the wafer for active layer subjected to the single-sided mirror-polishing step is bonded to a bonding surface of the wafer for support substrate.

In addition, it is more preferable that the polishing in the single-sided mirror-polishing is conducted until nanotopography measured in an area of 10 mm × 10 mm is reduced to not more than 10 nm and the finish polishing is conducted until a surface roughness (RMS value) measured in an area of 30 µm × 30 µm is reduced to not more than 1 nm. Thus, it is possible to further suppress the occurrence of voids on the bonded interface when the bonding surface of the wafer for active layer subjected to the single-sided mirror-polishing step is bonded to the bonding surface of the wafer for support substrate.

The nanotopography means a size of unevenness in an area of a few mm × a few mm to 20 mm × 20 mm on the front surface of the wafer when the rear surface is at a non-adsorption state, and the surface roughness (RMS value) means a root-mean-square of a size ofunevenness (roughness) of about a few nm to several tens of µm. Furthermore, the area of 10 mm × 10 mm indicates any area of 10 mm × 10 mm on the front surface of the wafer (single-sided mirror-polished surface). The nanotopography and the surface roughness (RMS value) can be calculated by measuring nanotopography and surface roughness (RMS value) at any one point in the areas or by measuring them at any several points and calculating the average, for example.

The diameter of the wafer for active layer according to the invention is preferable to be not less than 300 mm. Because, as the diameter of the wafer becomes larger, the production process for the wafer for active layer becomes more complicated and the production time and cost are increased, so that the effect by the production method of the invention (the wafer for active layer can be produced easily with low cost) can be developed most remarkably.

Furthermore, since the number of steps can be reduced, the margin for grinding or polishing is reduced by about 50% as compared with the conventional method, which can improve the production yield of the wafer for active layer.

Although the above is described with respect to only one embodiment of the invention, various modifications may be made without departing from the scope of the appended claims.

A semiconductor wafer is experimentally produced by the production method according to the invention, which will be described below.

### Example 1

According to the process flow of the invention shown in FIG. 1, five lots of sample wafers for active layer (25 wafers per lot: 125 wafers in total) are prepared by sequentially conducting a slicing step for cutting out a disc-shaped wafer having a diameter of 300 mm and a thickness of 700 µm from a single crystal silicon ingot (FIG. 1(a)), a beveling step for beveling an edge portion of the sliced wafer to prevent damages (FIG. 1(b)), a grinding step for grinding each surface of the beveled wafer with a grinding apparatus (FIG. 1(c)), an etching step for removing a machining strain on the surface of the ground wafer by an alkali etching with an etching solution containing 45% of KOH (FIG. 1(d)) and a single-sided mirror-polishing step for applying a polishing solution substantially containing no abrasive grain (less than 1% of KOH) onto a surface of a polishing pad having fixed abrasive grains and moving the polishing pad to polish only one surface of the alkali-etched wafer (a surface to be bonded for a bonded wafer) (FIG. 1 (e)).

In single-sided mirror-polishing step (FIG. 1(e)), polishing is conducted for reducing nanotopography on one surface of the wafer and further finish polishing is conducted for reducing surface roughness of one surface of the wafer, whereby nanotopography measured in an area of 10 mm × 10 mm of the wafer is reduced to 8 nm (not more than 10 nm) and surface roughness (RMS value) measured in an area of 30 µm × 30 µm is reduced to 0.9 nm (not more than 1 nm).

### Example 2

Five lots of sample wafers for active layer (125 wafers) are prepared under the same conditions as in Example 1 except that the wafer is cut out so as to have a thickness of 500 µm at the slicing step (FIG. 1(a)).

### Comparative Example 1

According to the production flow of the conventional production method (FIG. 2), a double-sided simultaneous grinding step (FIG. 2(b)) for grinding both surfaces of a wafer simultaneously is conducted after the wafer is cut out so that the thickness thereof is 900 µm (FIG. 2(a)), and then an edge polishing step (FIG. 2(f)) for polishing the edge portion of the wafer and a double-sided polishing step (FIG. 2(g)) for polishing both surfaces of the wafer simultaneously are carried out after the same beveling step (FIG. 2(c)), grinding step (FIG. 2(d)) and etching step (FIG. 1(e)) as in Example 1, whereby five lots of sample wafers for active layer (125 wafers) are prepared.

Evaluation is conducted with respect to each sample of the above Examples and Comparative Example.

### Non-defective product ratio

Each sample in Examples and Comparative Example is bonded to a normal wafer for support substrate, which is prepared separately, to produce a bonded wafer. Then, the number of wafers causing bonding failure such as voids or defects is counted to calculate non-defective product ratio every each sample lot (25 wafers) and then the average value among five lots. The results of the average of non-defective product ratio are shown in Table 1.

### Cost

With respect to Examples and Comparative Example, the cost required to produce the samples is calculated as a relative value when the cost for Comparative Example 1 is 1.

The evaluation results are shown in Table 1.

**Table 1**

| | Non-defective product ratio (%) | Production cost (value relative to Comparative Example 1) |
|---|---|---|
| Example 1 | 90< | 0.87 |
| Example 2 | 90< | 0.64 |
| Comparative Example 1 | 90< | 1 |

As seen from Table 1, the wafers for active layer obtained in Examples 1 and 2 have a non-defective product ratio nearly equal to the wafers for active layer produced by the conventional production method in Comparative Example 1, and the flatness is equal to that of the conventional product. On the other hand, the production cost is significantly reduced in Examples 1 and 2 as compared with Comparative Example 1. Furthermore, the cost is further reduced in Example 2 where the cut-out thickness of the wafer is thin in the slicing step as compared with Example 1.

According to the invention, it is possible to provide a method of producing a wafer for active layer in which an active layer having a good flatness can be produced easily with a low cost with respect to a large-size wafer particularly having a diameter of not less than 300 mm.

## Claims

1. A method of producing a wafer for active layer, which comprises a slicing step for cutting out a disc-shaped wafer from a single crystal silicon ingot, a beveling step for beveling an edge portion of the sliced wafer, a grinding step for grinding each surface of the beveled wafer, an etching step for etching the surface of the ground wafer and a single-sided mirror-polishing step for mirror-polishing only one surface of the etched wafer surfaces.

2. A method of producing a wafer for active layer according to claim 1, wherein the single-sided mirror-polishing step comprises a polishing for reducing nanotopography on one surface of the wafer and a finish polishing for reducing surface roughness of one surface of the wafer.

3. A method of producing a wafer for active layer according to claim 1 or 2, wherein the single-sided mirror-polishing step is conducted by applying a given polishing solution substantially containing no abrasive grain onto a surface of a polishing pad having fixed abrasive grains, and moving the polishing pad relative to a fixed silicon wafer to polish one surface of the wafer.

4. A method of producing a wafer for active layer according to claim 2 or 3, wherein the polishing in the single-sided mirror-polishing step is conducted until the nanotopography measured in an area of 10 mm × 10 mm is reduced to not more than 10 nm.

5. A method of producing a wafer for active layer according to any one of claims 2 to 4, wherein the finish polishing the single-sided mirror-polishing step is conducted until the surface roughness (RMS value) measured in an area of 30 µm × 30 µm is reduced to not more than 1 nm.

6. A method of producing a wafer for active layer according to any one of claims 1 to 5, wherein the wafer cut out from the ingot in the slicing step has a thickness of 300 to 700 µm.

7. A method of producing a wafer for active layer according to any one of claims 1 to 6, wherein a diameter of the wafer for active layer is not less than 300 mm.
